Europäisches Patentamt

European Patent Office

Office européen des brevets

(19)

(11) Numéro de publication: **0 014 117**
**B1**

(12) **FASCICULE DE BREVET EUROPEEN**

(45) Date de publication du fascicule du brevet: **06.07.83**

(51) Int. Cl.³: **H 03 H 9/145, H 03 H 9/64**

(21) Numéro de dépôt: **80400035.4**

(22) Date de dépôt: **11.01.80**

(54) Transducteur d'ondes élastiques de surface et filtre comprenant un tel transducteur.

(30) Priorité: **26.01.79 FR 7902100**

(43) Date de publication de la demande:
**06.08.80 Bulletin 80/16**

(45) Mention de la délivrance du brevet:
**06.07.83 Bulletin 83/27**

(84) Etats contractants désignés:
**DE GB IT NL**

(56) Documents cités:
**DE - A - 2 542 854**
**FR - A - 2 146 823**
**FR - A - 2 319 245**
**FR - A - 2 328 323**

(73) Titulaire: **THOMSON-CSF**
**173, Boulevard Haussmann**
**F-75379 Paris Cedex 08 (FR)**

(72) Inventeur: **Coussot, Cérard**
**"THOMSON-CSF" - SCPI 173, bld Haussmann**
**F-75360 Paris Cedex 08 (FR)**

(74) Mandataire: **Wang, Pierre et al,**
**THOMSON-CSF SCPI 173, Bld Haussmann**
**F-75379 Paris Cedex 08 (FR)**

Courier Press, Leamington Spa, England.

Transducteur d'ondes elastiques de surface et filtre comprenant un tel transducteur

La présente invention concerne les transducteurs d'ondes élastiques de surface.

Les dispositifs à ondes élastiques de surface comprennent habituellement deux jeux d'électrodes en forme de peignes interdigités déposés à la surface d'un substrat piézoélectrique. Une tension électrique que l'on veut traiter (par exemple filtrer ou retarder) est appliquée à l'un des jeux qui s'appelle transducteur d'émission, afin de provoquer l'émission d'ondes élastiques de surface en direction de l'autre jeu qui s'appelle transducteur de réception et qui délivre une tension dont les caractéristiques dépendent du mode vibratoire transmis et de la configuration des peignes transducteurs.

L'une des caractéristiques importantes d'un dispositif à ondes élastiques de surface est sa réponse en fréquence qui est le produit des réponses des deux transducteurs. On sait que l'enveloppe de la réponse impulsionnelle d'un transducteur est reproduite dans le dessin formé par les extrémités des dents d'au moins une des électrodes du transducteur. C'est ainsi, par exemple, que l'on obtient un filtre passe-bande lorsque l'un des deux transducteurs a des dents d'inégales longueurs décrivant une courbe représentant la fonction sin/x, tout au moins son lobe central et ses lobes secondaires principaux. La fréquence centrale est définie par l'écart entre deux dents successives d'un même peigne et la largeur de bande est liée à la longueur du transducteur. La fonction de transfert du filtre est toutefois liée à d'autres paramètres qui introduisent des effets parasites sur lesquels il est difficile d'agir. L'un de ces effets est constitué par les réflexions des ondes de surface sur les dents successives. Ces réflexions introduisent des pertes de transmission, qui peuvent être variables en fonction de la fréquence, entrainant des déformations dans la bande passante. Il est connu de neutraliser les ondes ainsi réémises à chaque dent, en réalisant des peignes à dents divisées, de façon que les ondes réfléchies successives se trouvent en opposition de phase en donc s'annulent, au lieu de s'ajouter, comme c'est le cas avec des dents pleines. Toutefois cette neutralisation n'empêche pas, si le coefficient de réflexion est élevé, les pertes de transmission. On constate expérimentalement que le coefficient de réflexion dépend fortement de l'impédance de charge des deux peignes, cette impédance étant constituée par exemple, pour un transducteur d'émission, de l'impédance interne du circuit auquel est raccordé le dispositif à ondes de surface considéré. D'après les résultats des expériences, lorsque cette impédance de charge est faible, le coefficient de réflexion est faible avec des peignes à dents divisées, alors qu'il est élevé avec des peignes à dents pleines. Par contre, lorsque cette impédance de charge est élevée, le coefficient de réflexion est élevé avec

des peignes à dents divisées. L'invention vise un transducteur permettant d'obtenir la caractéristique de transfert choisie, avec des peignes à dents divisées pour éviter la réémission d'ondes parasites, mais tel que le coefficient de réflexion soit faible, même lorsque les électrodes sont reliées par une impédance élevée.

L'invention s'applique aus transducteurs dont la réponse impulsionnelle comporte des lobes secondaires. Cette réponse est donc formée typiquement d'un grand lobe central et de lobes secondaires symétriques par rapport au lobe central. Habituellement, l'axe longitudinal des lobes secondaires est celui du lobe central; une onde se propageant depuis les premiers lobes secondaires vers le lobe central rencontre alternativement des dents des deux peignes, entre lesquels existe l'impédance de charge. Il est connu par le document DE—A—2 542 854 de réaliser un transducteur interdigité pour ondes élastiques de surface qui comporte une zone active pour synthétiser le lobe principal et une zone active pour synthétiser un lobe secondaire. Ces deux zones actives présentent un excentrement par rapport à la direction de propagation des ondes élastiques de surface mais le rayonnement qui parvient de la zone active du lobe secondaire rencontre la zone active synthétisant le lobe principal dans une région couvrant pratiquement la totalité de la largeur du lobe synthétisé. Il en résulte que l'excentrement proposé par le document DE—A—2 542 854 n'a pas pour objet de minimiser l'interaction du rayonnement issu du lobe secondaire avec la zone active du lobe principal. L'invention consiste à décaler les lobes secondaires, ou seulement le plus petit lobe secondaire existant, de façon que son axe ne coincide plus avec l'axe du lobe central, mais se trouve en vis à vis du maximum de ce lobe central.. Ainsi, l'onde se propageant à partir de ce petit lobe rencontre en majorité des dents appartenant à un même peigne et peu de dents appartenant à l'autre peigne. Les dents d'un même peigne étant en court-circuit, le coefficient de réflexion sur ces dents est très faible. Par ce moyen, on aura diminué le coefficient de réflexion global, et ce d'autant plus que les flans du grand lobe de part et d'autre du maximum seront plus raides.

L'invention sera mieux comprise et d'autres caractéristiques apparaitront au moyen de la description ci-après, présentée à titre d'exemple non limitatif, et des figures annexées où:

La figure 1 représente un transducteur d'ondes de surface de type connu.

La figure 2 représente un transducteur à doigts divisés de type connu.

La figure 3 comprend trois courbes représentatives du coefficient de réflexion.

La figure 4 représente un transducteur d'ondes de surface selon l'invention.

La figure 5 représente une variante de transducteur selon l'invention.

La figure 6 illustre une application de l'invention à un filtre.

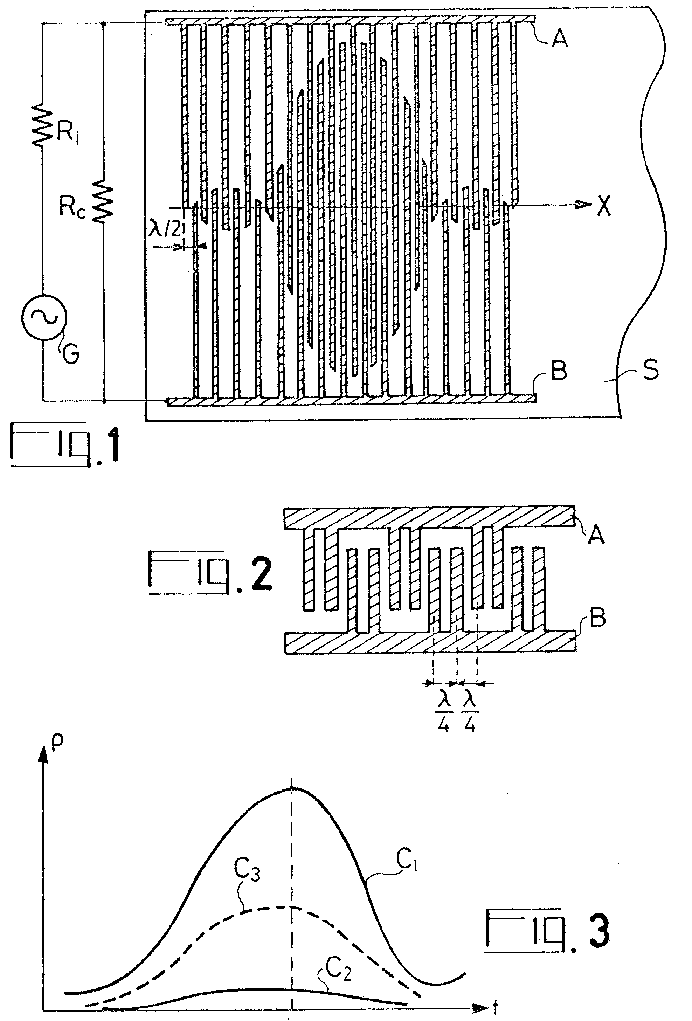

La figure 1 représente un transducteur d'ondes de surface de type connu. Ce transducteur est constitué de deux peignes A et B formés de dépôts métalliques à la surface S d'un substrat piézoélectrique faisant partie d'un dispositif à ondes élastiques de surface. Les peignes A et B sont à doigts intercalés. Les longueurs des doigts sont inégales et forment deux courbes d'allure sinx/x de sorte que la réponse impulsionnelle de ce transducteur est de la forme sin x/x. En réalité, seul le lobe principal et un ou plusieurs lobes secondaires sont effectivement représentés dans le dessin du transducteur. La réponse en fréquence d'un tel transducteur est celle d'un filtre passe-bande dont la fréquence centrale est déterminée par l'écart entre deux dents successives d'un même peigne, cet écart étant égal à $\lambda/2$ où $\lambda$ est la longueur d'onde au centre de la bande. La largeur de bande dépend de la longueur du transducteur. Des inconvénients résultent des réflexions des ondes de surface sur les dents successives. En effet les ondes se propageant de doigt en doigt se trouvent réfléchies par ces doigts et les ondes réfléchies par deux doigts successifs se trouvent en phase du fait de l'écartement des dents, et s'ajoutent.

Une amélioration déjà connue pour éviter ces inconvénients est représentée sur la figure 2 dans le cas d'un transducteur avec des doigts d'égale longueur. Cette amélioration réside dans le fait de diviser les doigts en deux bandes métalliques hachurées sur la figure. La distance entre deux bandes, qu'elles appartiennent à un même peigne ou à deux peignes différents, est égale à $\lambda/4$. Les ondes réfléchies par deux bandes successives se trouvent donc en opposition de phase et s'annulent. On évite ainsi que des ondes parasites soient émises en même temps que l'onde principale. Mais on n'évite pas pour autant le phénomène de la réflexion qui introduit une atténuation de l'onde obtenue à la sortie du transducteur, cette atténuation étant variable avec la fréquence ce qui crée des distorsions de bandes passantes. En fait, le coefficient de réflexion dépend de l'impédance existant entre les deux peignes A et B. Le transducteur représenté sur la figure 1 est un transducteur d'émission, il est relié à un circuit d'entrée dont le schéma équivalent peut être un générateur G délivrant une tension alternative et possédant une impédance interne série $R_i$, en parallèle avec une impédance de charge $R_c$. Cette impédance $R_c$ peut être, pour simplifier, assimilée à une résistance.

Sur la figure 3 sont représentées les variations du coefficient de réflexion sur un doigt d'un onde élastique provenant du doigt situé en amont, en fonction de la fréquence f de cette onde, pour différents cas. La courbe $C_1$ correspond à des doigts divisés entre lesquels existe une charge infinie; on constate expérimentalement que le coefficient de réflexion est éleve, particulièrement autour de la fréquence $f_o$ centrale de la bande du transducteur. La courbe $C_2$ correspond à des dents divisées entre lesquelles existe une charge nulle, c'est le cas par exemple lorsque les deux doigts successifs considérés appartiennent à un même peigne; on constate que le coefficient de réflexion est alors faible. La courbe $C_3$ correspond à un cas intermédiaire où les deux dents considérées appartiennent à deux peignes différents reliés par une haute impédance. Ce cas se présente notamment lorsque le transducteur est la transducteur d'entrée d'un dispositif à ondes de surface raccordé au circuit collecteur d'un transistor bipolaire, ou au circuit de drain d'un transistor à effet de champ, ou bien lorsqu'il s'agit d'un transducteur de sortie relié à grille d'un transistor à effet de champ. En se référant à la figure 1, on considère une onde dont le sens de propagation X est selon l'axe des lobes de la réponse impulsionnelle. L'onde est donc issue d'un petit lobe en direction du lobe principal; elle rencontre successivement des doigts appartenant à des peignes différents, donc entre lesquel existe l'impédance $R_c$.

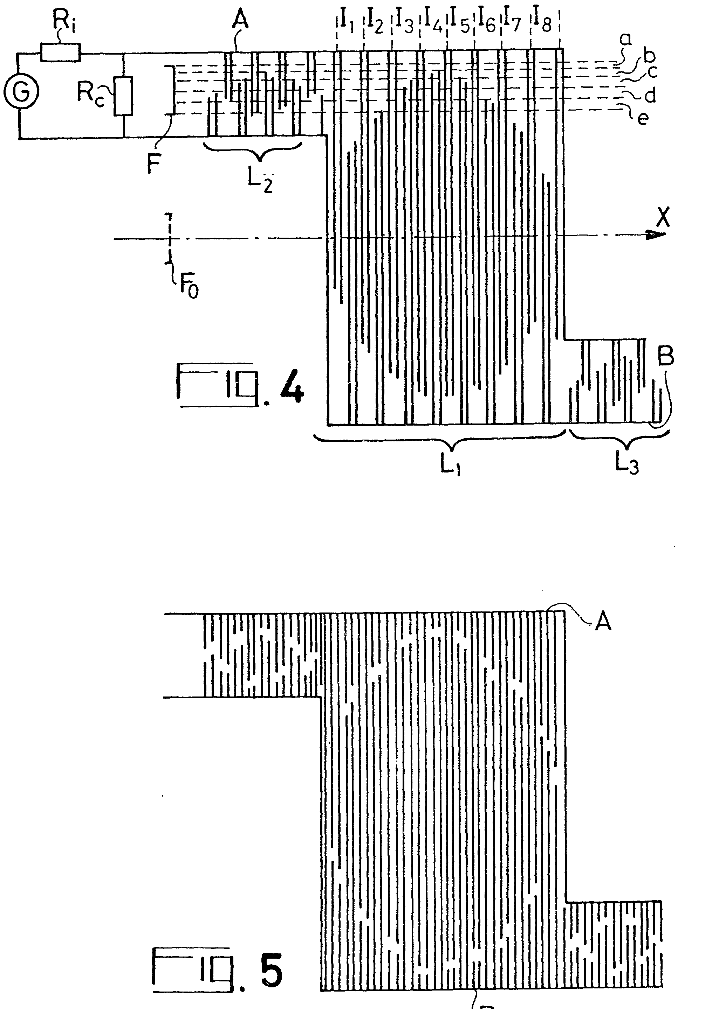

Sur la figure 4 est représentée une nouvelle configuration de transducteur ayant la même réponse en fréquence que celui de la figure 1 et des doigts divisés comme sur la figure 2. Cette configuration comporte de part et d'autre du grand lobe $L_1$ deux petits lobes $L_2$ et $L_3$ dont les axes sont décalés par rapport à l'axe du grand lobe. Le lobe $L_2$ se trouve alors en vis à vis d'un des maxima du lobe $L_1$, le lobe $L_3$ se trouvant vis à vis de l'autre maximum du lobe $L_1$. Ainsi le front d'onde F schématiquement illustré sur la figure qui est émis par le lobe $L_2$, en arrivant sur le lobe $L_1$ rencontre essentiellement des doigts appartenant au même peigne A, ces doigts se trouvent donc en court-circuit. De même l'onde issue du grand lobe $L_1$ arrivant sur le lobe $L_3$ provient d'une zone où les dents appartiennent toutes au même peigne B. Pour expliquer schématiquement le phénomène on peut partager la zone du grand lobe sur laquelle arrive le front F en intervalles rayonnants $I_1$, $I_2$, ..., $I_8$ se succédant dans cet ordre dans le sens de propagation X, et en canaux élémentaires parallèles à X: a, b, c, d, e. On constate que dans le canal a tous les doigts appartiennent au même peigne A, dans le canal b on a un seul intervalle rayonnant $I_4$; dans les canaux c et d on a trois intervalles $I_3$, $I_4$, $I_5$; dans le canal e on a quatre intervalles rayonnants $I_3$, $I_4$, $I_5$. Pour chaque canal, les intervalles rayonnants peuvent être assimilés à des sources ultrasonores d'amplitude variable retardées les unes sur les autres et dont les contributions s'ajoutent. Si le lobe secondaires $L_2$ avait été placé comme dans la figure 1, le front d'onde arrivant sur le lobe $L_1$ aurait eu l'allure $F_o$ représentée en pointillés et n'aurait rencontré que des intervalles rayonnants, c'est à dire des dents appartenant successivement aux deux peignes A et B, entre lesquelles existe la charge $R_c$. Les intervalles $I_1$ à $I_8$ étant placés électriquement en cascade, les réflexions successives s'ajoutent, si bien que la configuration de l'invention permet de faire diminuer le coefficient de réflexion total. Le lobe $L_3$ est placé de façon symétrique au lobe $L_2$ par rapport au centre du lobe $L_1$. Cet emplacement n'est pas critique, il pourrait être différent.

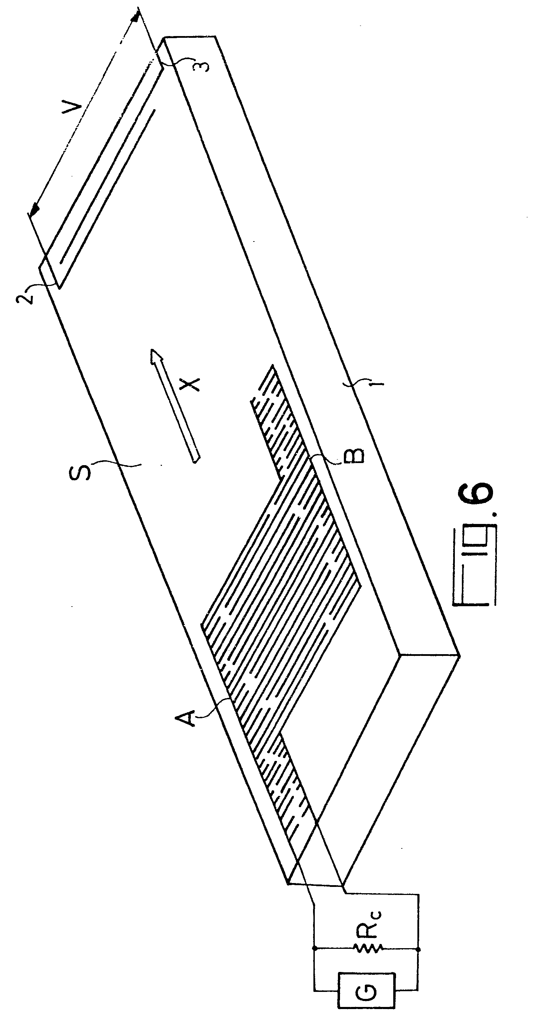

La figure 5 représente une variante de réalisation de l'invention, elle utilise un procédé connu en soit pour éviter les distorsions du front d'onde résultant des différences de longueurs des dents. A cet effet chaque peigne est formé alternativement de dents dites actives et de dents dites mortes. Seuls les couples de dents actives forment les éléments rayonnants. Les dents mortes sont placées en vis à vis des dents actives laissant seulement un faible intervalle. Ces intervalles décrivent une courbe correspondant à l'enveloppe de la réponse impulsionnelle du transducteur.

Sur la figure 6 est représentée une application de l'invention à un filtre à ondes élastiques de surface. Un tel filtre est constitué d'un substrat piézoelectrique 1 sur l'une des faces S duquel sont déposés un transducteur d'entrée formé de deux peignes A et B selon l'invention, c'est à dire tel que représenté par exemple sur la figure 4 ou sur la figure 5, et un transducteur de sortie formé de deux peignes 2 et 3 par exemple à une seule dent. Un générateur G en parallèle avec une impédance de charge $R_c$, assimilables à une source de courant sont connectés entre les deux peignes A et B. On recueille entre les deux peignes 2 et 3 une tension V qui correspond à la tension délivrée par le générateur G filtrée selon les caractéristiques du transducteur d'émission.

L'invention ne s'applique pas seulement aux filtres, mais à tous dispositifs à ondes élastiques de surface propagées entre deux transducteurs à la surface d'un substrat piézoélectrique notamment ceux comprenant un transducteur à dents d'inégale longueur dont la réponse impulsionnelle comporte des lobes secondaires.

## Revendications

1. Transducteur d'ondes élastiques de surface du type comprenant des électrodes métalliques se présentant sous forme de deux peignes interdigités ayant des dents actives d'inégales longueurs de façon à former une succession d'intervalles rayonnants destinés à émettre et à recevoir des ondes élastiques de surface se propageant suivant und direction X, lesdits intervalles rayonnants formant une disposition reproduisant l'enveloppe de la réponse impulsionnelle du transducteur, chaque dent active étant formée de deux bandes métalliques parallèles distantes de $\lambda/4$, $\lambda$ étant la longueur d'onde correspondant à la fréquence centrale du spectre de transmission du transducteur, cette réponse impulsionnelle comportant au moins un lobe principal central et un lobe secondaire situé en amont du lobe principal, la zone active synthétisant le lobe principal étant décalée perpendiculairement à la direction de propagation par rapport à la zone active synthétisant le lobe secondaire, caractérisé en ce que ledit décalage est tel que les ondes émises en provenance de la zone active synthétisant le lobe secondaire rencontrent la zone active synthétisant le lobe principal seulement dans la région du maximum du lobe principal.

2. Transducteur selon la revendication 1, caractérisé en ce que chaque peigne comporte alternativement des dents actives et des dents mortes, seules les dents actives de l'un et l'autre peigne se recouvrant pour former les éléments rayonnants.

3. Transducteur selon l'une quelconque des revendications 1 et 2, caractérisé en ce que le transducteur est un transducteur d'émission transformant de l'énergie électrique en énergie élastique, les deux peignes étant reliés à une source présentant une impédance haute par rapport à celle dudit transducteur.

4. Filtre à ondes élastiques de surface du type comprenant un substrat piézoélectrique sur la surface duquel sont placés au moins un transducteur d'émission et un transducteur de réception, caractérisé en ce que l'un des transducteurs est selon l'une quelconque des revendications 1 à 3.

## Claims

1. An elastic surface wave transducer of the type comprising metallic electrodes in the form of two combs having intermeshing teeth of different lengths, so as to form a row of radiating intervals adapted to emit and receive elastic surface waves which propagate in a direction X, said radiating intervals forming an arrangement which reproduces the pulse response envelope of the transducer, each active tooth being constituted by two parallel metallic strips spaced $\lambda/4$ apart, wherein $\lambda$ is the wave length corresponding to the central frequency of the transmission spectre of the transducer, said pulse response comprising at least one central main lobe and one secondary lobe located upstream of the main lobe, the active zone synthetizing said main lobe being shifted perpendicularly to the propagation direction with respect to the active zone synthetizing said secondary lobe, characterized in that said shifting is so selected that the waves emitted from the active zone synthetizing said secondary lobe meet the active zone synthetizing said main lobe only in the area of the maximum of the main lobe.

2. A transducer according to claim 1, characterized in that each comb comprises alternately arranged active teeth and dead teeth, only the respective active teeth of each one of said combs being disposed in an overlapping position, so as to form the radiating elements.

3. A transducer according to any one of claims 1 and 2, characterized in that said transducer is an emitting transducer converting electric energy into elastic energy, said two combs being connected to a source the impedance of which is high as compared to the impedance of said transducer.

4. An elastic surface wave filter of the type comprising a piezoelectric substrate on the surface of which are disposed at least one emitting transducer and one receiving transducer, characterized in that one of said transducers is a transducer according to any one of claims 1 to 3.

**Patentansprüche**

1. Transduktor für elastische Oberflächenwellen, mit zwei als ineinander greifende Kämme ausgebildeten metallischen Elektroden, die aktive Zähne verschiedener Länge aufweisen, derart, dass sie eine Reihe von Strahlzwischenräumen bilden, die zum Abgeben und Empfangen der sich in einer Richtung X fortpflanzenden elastischen Oberflächenwellen geeignet sind, wobei diese Strahlzwischenräume eine der Umhüllungskurve des Impulsganges des Transduktors entsprechende Anordnung bilden, wobei jeder aktive Zahn aus zwei parallelen, mit einem gegenseitigen Abstand von $\lambda/4$ angeordneten metallischen Streifen gebildet ist, wo $\lambda$ die der Mittelfrequenz des Übertragungsspektrum des Transduktors entsprechende Wellenlänge darstellt, wobei dieser Impulsgang wenigstens einen mittleren Hauptlappen und einen vor dem Hauptlappen gelegenen Sekundärlappen umfasst, und wobei der den Hauptlappen zusammenfassende aktive Bereich senkrecht zur Fortpflanzungsrichtung in bezug auf den den Sekundärlappen zusammenfassenden aktive Bereich versetzt ist, dadurch gekennzeichnet, dass diese Versetzung derart gewählt ist, dass die dem den Sekundärlappen zusammenfassenden aktive Bereich ausgehenden Wellen den den Hauptlappen zussammensetzenden aktiven Bereich lediglich in der das Maximum des Hauptlappens enthaltenden Zone treffen.

2. Transduktor nach Anspruch 1, dadurch gekennzeichnet, dass jeder Kamm abwechselnd angeordnete aktive und inaktive Zähne besitzt, wobei sich lediglich die jeweiligen aktiven Zähne des einen und des anderen Kammes überdecken, um die Strahlelemente zu bilden.

3. Transduktor nach einem der Ansprüche 1 und 2, dadurch gekennzeichnet, dass er einen elektrische Energie in elastische Energie umwandelnden Sendetransduktor bildet, wobei die beiden Kämme an eine Quelle angeschlossen sind, die in bezug auf die Impedanz des Transduktors hohe Impedanz besitzt.

4. Filter für elastische Oberflächenwellen mit einer piezoelektrischen Trägerschicht, auf deren Oberfläche wenigstens ein Sendetransduktor und ein Empfangstransduktor angeordnet sind, dadurch gekennzeichnet, dass einer der Transduktoren ein Transduktor nach einem der Ansprüche 1 bis 3 ist.

**Fig.1**

**Fig.2**

**Fig.3**

Fig.4

Fig.5

Fig.6